# EUROPEAN PATENT SPECIFICATION

(11) **EP 0 305 946 B1**
(45) Date of publication and mention of the grant of the patent: **30.10.1996**
(21) Application number: 88114049.5
(22) Date of filing: 29.08.1988
(51) Int. Cl.: G03F 7/42

(54) **Method for removing organic and/or inorganic films by dry plasma ashing**
Plasma-Entschichtungsverfahren für organische und anorganische Schichten
Procédé d'enlèvement de films organique et/ou minéraux par plasma

(30) Priority: 28.08.1987 JP 213082/87; 29.09.1987 JP 242660/87; 30.05.1988 JP 130385/88; 05.02.1988 JP 25155/88
(43) Date of publication of application: 08.03.1989
(73) Proprietor: KABUSHIKI KAISHA TOSHIBA, Kawasaki-shi, Kanagawa-ken 210 (JP)
(72) Inventor: Hayaska, Nobuo, Kanazawa-ku Yokohama-shi Kanagawa-ken (JP); Arikada, Tsunetoshi, Edogawa-ku Tokyo (JP); Okano, Haruo, Ohta-ku Tokyo (JP); Horioka, Keiji, Tama-ku, Kawasaki-shi Kanagawa-ken (JP)
(74) Representative: Lehn, Werner, Dipl.-Ing.

(56) References cited:
- EP-A- 0 212 924
- EP-A- 0 216 603
- EP-A- 0 234 387
- US-A- 4 501 061
- JOURNAL OF THE ELECTROCHEMICAL SOCIETY, vol. 129, no. 11, November 1982, pages 2537-2541, Manchester, New Hampshire US; S. DZIOBA et al.: "Decapsulation and photoresist stripping in oxygen microwave plasmas"
- JOURNAL OF THE ELECTROCHEMICAL SOCIETY, vol. 133, no. 9, September 1986, pages 1922-1925, Manchester, NH, US; J.E. SPENCER et al.: "High rate photoresist stripping in an oxygen afterglow"
- IBM TECHNICAL DISCLOSURE BULLETIN, vol. 28, no. 7, December 1985, pages 2828- 2829, New York, US; "NMP strip of photoresist after CF4-H2 RIE etch"
- JAPANESE PATENT REPORT, section Ch: Chemical, vol. 78, no. 44, page G3, Derwent Publications Ltd, London, GB; & JP-B-78 040 536

## Description

### BACKGROUND OF THE INVENTION

### Field of the Invention

The present invention relates to method and apparatus for removing an organic or inorganic film or the like in a dry plasma ashing for use in a photo resist or a surface treatment of a semiconductor manufacturing process and the like.

### Description of the Prior Art

In a conventional apparatus for manufacturing a semiconductor or the like, it is important and essential to conduct a photo etching process (PEP) with an organic compound film such as a photosensitive photoresist as a mask in finely processing a printed circuit board, a compact disc or a laser disc. Then, this organic compound photoresist is removed after finishing a processing such as an etching and an ion-implanting of a main plate or board. The removal of the photoresist is mainly carried out in a wet chemical etching process, e.g., in a mixed solution of a sulfuric acid and a hydrogen peroxide or another mixed solution of the former mixed solution and water added thereto, or in a dry plasma etching process, e.g., in a dry ashing with oxygen gas dissociated by discharge.

In the wet chemical etching process, there are some problems in controlling the acidic solution and the safety of the operation. Particularly, this process is not suitable for a process for manufacturing a semiconductor which dislikes a process using a liquid, and further, when an organic compound photoresist is used for patterning a metallic electrode material such as aluminum or the like in a semiconductor producing process, the metallic electrode can be eaten easily by the acidic mixed solution of the sulfuric acid and the hydrogen peroxide. Thus, the application of the wet chemical etching process is restricted.

In the dry plasma ashing process which removes the problems of the wet chemical etching process, the organic compound photoresist can be removed in the dry ashing by the oxygen plasma. In this case, a material to be etched is placed in a barrel type or parallel plate type reactor, and the oxygen gas introduced therein is dissociated by the discharge therein to produce the oxygen plasma. The organic compound photoresist is removed using the oxygen plasma. In this process, as compared with the wet chemical etching process, the processing is conducted in a simple way and the material to be etched is not limited to the nonmetallic materials. However, in the dry plasma ashing method, the electric discharge is practiced in the reactor containing the material to be treated in order to attain a certain removing speed in practice, and hence the material is damaged on its surface or a resist residue is produced on the surface.

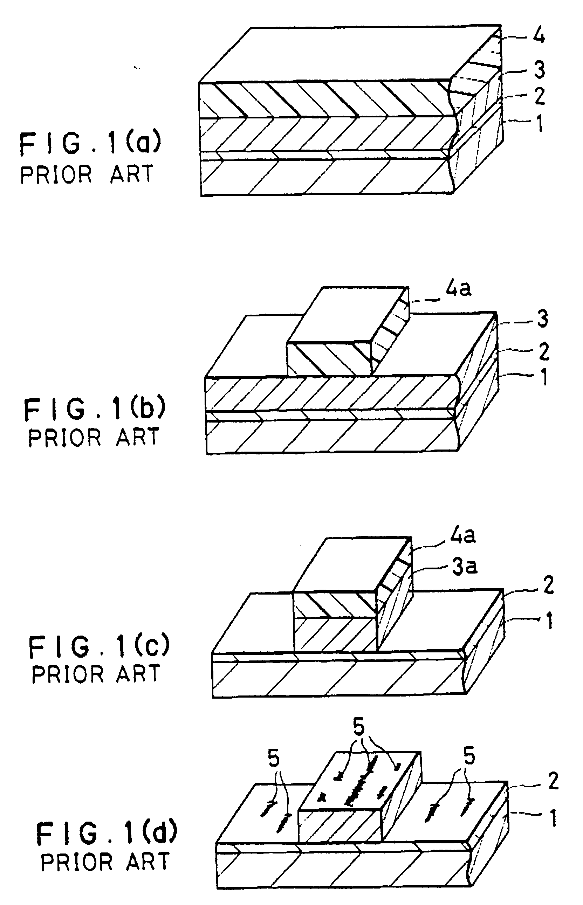

An example of a process for producing a gate electrode on a semiconductor plate of a MOS semiconductor device in a conventional photo etching process using an oxygen plasma will be described in connection with Fig. 1.

First, a phosphorus-added poly-crystalline silicon film 3 for a gate electrode is formed on a semiconductor base plate 1 via an oxide film 2 formed thereon, and an organic compound photoresist film 4 is applied over the poly-crystalline silicon film 3, as shown in Fig. 1a. Then, a pattern light exposure is carried out and is then developed so as to obtain the desired partial resist film 4a on the gate electrode film 3, as shown in Fig. 1b. By utilizing the partial resist film 4a as a mask, a partial gate electrode film 3a right under the partial resist film 4a is left by etching the other part of the poly-crystalline silicon film 3 in the reactive ion etching (RIE) process or the like, as shown in Fig. 1c. Finally, the partial photoresist film 4a is removed from the poly-crystalline film 3a in the dry plasma ashing process using the aforementioned oxygen plasma, as shown in Fig. 1d.

However, when the partial photoresist film 4a is removed from the gate electrode film 3a, as shown in Fig. 1d, the residues 5 of the ashed organic compound may be often produced on the surfaces of the gate electrode film 3a and the oxide film 2. Further, by the attack of the charged particles produced by the discharge during the removing step of the photoresist film 4a, the damages may be caused in the oxide film 2 and the semiconductor plate 1. Accordingly, in the MOS semiconductor device produced as described above, the residues 5 may affect bad influences to the followed processes or the characteristics of the semiconductor, for example, the resistivity of the oxide film may be deteriorated.

These problems arise in both the barrel type and the parallel plate type ashing reactors. In the latter reactor, the charged particles mainly impact against the surface of the material to be removed during the discharge and thus the damage of the material is larger than that in the former reactor.

Further, in the oxygen plasma ashing process, usually, the charged particle such as oxygen radical and ozone does not react with the photoresist of the material to be removed at a practical speed at a low temperature such as below approximately 100°C, and hence heat or another energy instead of the heat is added to the material placed in the plasma. When the material is heated, the inside of the photoresist is carbonized. Therefore, it is more difficult to remove the residue of the organic compounds exposed by the charged particles during the dry plasma ashing, and the residues are apt to remain on the surfaces of the material, in comparison with another process including no dry plasma ashing step.

In order to completely remove the residues 5, it is necessary to perform the oxygen plasma ashing for a long time, for instance, more than one hour, which is inconvenient and disadvantageous for realizing the manufacturing process, and further in such a long oxygen plasma ashing process, the damage to the material is enlarged. Then, the temperature in the reactor is raised to more than 100°C for improving the etching rate, but this requires a large and complicated processing apparatus. Further, in turn, the residues are liable to be produced at the high temperature, and the residues cannot be completely removed.

On the other hand, nowadays, a pattern size of an integlated circuit for a semiconductor is remarkably diminished to such as a submicron order in a common process. As steps in a semiconductor manufacturing process proceed, a surface of a base plate becomes more uneven and more complicated. When a fine pattern is formed on the uneven and complicated surface of the plate, the dimensional accuracy is remarkably lowered. That is, the dimensions become smaller in the convex surface portions and larger in the concave surface portions.

In order to overcome this problem, a multilayer resist method has been developed. In this case, for instance, an aluminum film is applied over an uneven semiconductor base plate with an uneven aluminum surface, and then a first photoresist is overlaid on the uneven aluminum film with a flattened photoresist surface. Then, a thin film of a material such as silicon oxides having a resistance against the oxygen plasma is uniformly applied over the flat surface of the first photoresist, and a second photoresist is then evenly formed over the flat surface of the plasma-resistant film. The pattern light exposure and the developing of the second photoresist film are conducted to form the desired pattern thereof with an excellent dimensional accuracy because the surface of the second photoresist film is uniform, and then the etching of the plasma-resistant film is carried out in a certain direction, for example, perpendicular to the flat surface plane of the second photoresist, using the patterned second photoresist as the mask. Next, the first photoresist film is etched in the predetermined direction perpendicular to the flat surface plane of the plasma-resistant film, in the oxygen plasma ashing process using the plasma-resistant film as the mask to form a pattern having a high dimensional accuracy. Further, the etching of the aluminum film laid over the semiconductor plate is performed in the oxygen plasma ashing process using the patterned first photoresist film as the mask with an accurate etched pattern on the uneven semiconductor base plate in the same manner as above.

However, in the aforementioned etching processes using the oxygen plasma, the etched aluminum of the aluminum film is sputtered and attaches to the side walls of the patterned plasma-resistant film, the etched first photoresist and the etched aluminum film during the plasma ashing process.

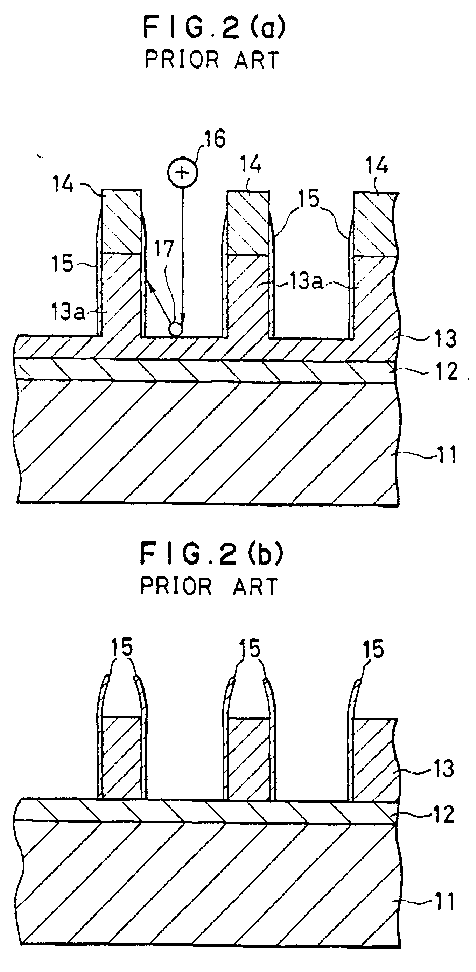

Fig. 2 schematically illustrates an etching process of an aluminum film 13 applied over an oxide film 12 of a semiconductor base plate 11 using a patterned photoresist 14 laid on the aluminum film 13. In this embodiment, during the reactive ion etching process, a charged particle 16 perpendicularly impacts on the aluminum film 13 to sputter the aluminum film 13, and an etched aluminum spatter 17 attaches to the side walls of the photoresist 14 or the patterned aluminum layer 13a to form aluminum film walls 15 thereon, as shown in Fig. 2a. The aluminum film walls 15 can prevents the attacks of the charged particles and thus plays an important roll to form a precise and fine pattern. However, after the aluminum pattern forming by etching using the photoresist as the mask is finished, the photoresist 14 can be removed by the dry plasma ashing process, but the aluminum film walls 15 cannot be removed, as shown in Fig. 2b.

Such film walls of a material to be etched may be formed regardless of the kind of the material during the dry plasma ashing process. For instance, when a polycrystalline silicon is etched, silicon film walls are formed in the same manner as the aluminum film walls when the aluminum material is etched, as described above. Usually, the aluminum film walls can be removed in the wet chemical etching treatment, for example, using an etching solution containing a hydrofluoric acid, but, at the same time, the aluminum pattern and the insulating material of silicon oxide film below the aluminum pattern can also be etched in the etching solution. In the case of the poly-crystalline silicon, the gate oxide film under the poly-crystalline silicon pattern can be etched as well.

When a halogen radical having a strong reactivity, obtained by activating a gas including halogen element or element such as fluorine is used for etching, the halogen radical can solely react with the organic compound film to remove it. However, when the photoresist or the gate electrode formed on the silicon or silicon oxide base film is etched by the halogen radical alone, the base film is also etched, and hence the halogen radical alone cannot be used for the etching process. Further, the etching rate of the organic compound film using the halogen radical alone becomes approximately 1000Å/min which is not so quick, in practice.

### SUMMARY OF THE INVENTION

Accordingly, it is an object of the present invention to provide a method for removing an organic or inorganic film in a dry plasma etching, free from the aforementioned defects and disadvantages of the prior art, which is capable of quickly and exactly removing a photoresist and side walls formed on sides of an etched pattern by attaching etched material spatters thereto during the etching, in a dry process to obtain a pattern having an excellent dimensional accuracy without giving any damages against the pattern and a base plate under the pattern.

In accordance with one aspect of the invention, there is provided a method for removing a film from the surface of a substrate located in a chamber by dry plasma etching comprising the steps of:
generating fluorine radicals outside the chamber from a fluorine-containing gas; and
separately feeding the fluorine radicals and a second gas selected from hydrogen, water, an alcohol and a hydrocarbon into the chamber where they react to form radicals for performing the dry plasma etching.

### BRIEF DESCRIPTION OF THE DRAWINGS

These and other objects, features and advantages of the present invention will more fully appear from the description of the preferred embodiments with reference to the accompanying drawings, in which:
Fig. 1 is a schematic perspective view showing a conventional plasma etching process;
Fig. 2 is a schematic longitudinal cross sectional view showing another conventional etching process;
Fig. 3 is a schematic longitudinal cross sectional view of a first embodiment of an apparatus for removing organic and inorganic film according to the present invention;
Fig. 4 is a schematic perspective view showing an etching process of a specimen, conducted in the apparatus shown in Fig. 3;
Fig. 5 is a graphical representation showing a relation between a photoresist etching speed and a variation of water supplied in the apparatus of Fig. 3;
Fig. 6 is a schematic longitudinal cross sectional view, like Fig. 3, of a second embodiment of the apparatus including a cooling device for a material according to the present invention;
Fig. 7 is a graphical representation showing a relation between a photoresist temperature and an ashing time in the apparatus of Fig. 6;
Fig. 8 is a graphical representation showing a relation between a photoresist etching speed and a temperature of a material in the apparatus of Fig. 6;
Fig. 10 is a perspective view of a first embodiment of nozzles for supplying gases to the material to be etched in the apparatus according to the present invention;
Fig. 11 is a schematic longitudinal cross sectional view of a second embodiment of the nozzles used in the apparatuses according to the present invention;
Fig. 12 is a schematic longitudinal cross sectional view of a third embodiment of the nozzle used in the apparatuses according to the present invention;
Fig. 13 is a longitudinal cross sectional view of a fourth embodiment of the nozzle used in the apparatuses according to the present invention;
Fig. 14 is a transverse cross sectional view of embodiments of an opening portion of the nozzle of Fig. 13;
Fig. 15 shows a fifth embodiment of a nozzle including a plurality of the nozzles shown in Fig. 13;
Fig. 16 is a longitudinal cross sectional view of a sixth embodiment of the nozzle used in the apparatuses according to the present invention;
Fig. 17 is a graphical representation showing a relation between a photoresist etching speed and a distance from the center on the surface of the material to be etched using the nozzle of Fig. 16;
Fig. 18 is a schematic longitudinal cross sectional view of a fourth embodiment of the apparatus including a parallel plate electrodes according to the present invention;
Fig. 19 is a schematic longitudinal cross sectional view, like Fig. 18, of a fifth embodiment of the apparatus including a cooling device for the material to be etched according to the present invention;
Fig. 20 is a schematic longitudinal cross sectional view of a sixth embodiment of the apparatus according to the present invention;
Fig. 21 is a schematic longitudinal cross sectional view showing an etching process performed in the apparatus of Fig. 20;
Fig. 22 is a schematic longitudinal cross sectional view of a seventh embodiment of the apparatus according to the present invention;
Fig. 24 is a schematic longitudinal cross sectional view of a ninth embodiment of the apparatus according to the present invention;
Fig. 25 is a schematic longitudinal cross sectional view of a tenth embodiment of the apparatus according to the present invention;
Fig. 26 is a schematic longitudinal cross sectional view of an eleventh embodiment of the apparatus according to the present invention;
Fig. 27 is a schematic longitudinal cross sectional view of an etching process conducted in the apparatus of Fig. 26;
Fig. 28 is a graphical representation showing a relation between an NF₃ amount and removable an unremovable areas of the material in the etching process of Fig. 27; and
Fig. 29 is a schematic longitudinal cross sectional view of another etching process performed in the apparatus of Fig. 26.

### DESCRIPTION OF THE PREFERRED EMBODIMENTS

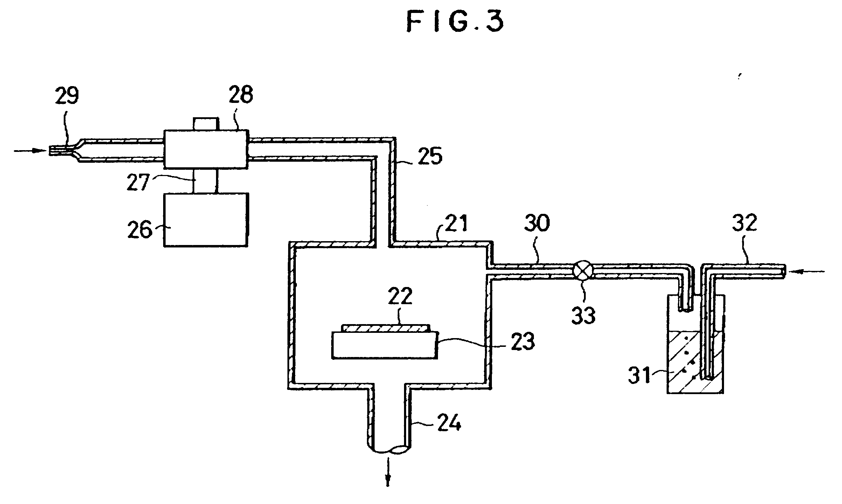

Referring now to the drawings, wherein like reference characters designate like or corresponding parts throughout the several views, there is shown in Fig. 3 a first embodiment of an apparatus for removing organic and inorganic film by a dry plasma etching according to the method of the present invention.

In the drawing, the down-flow type apparatus comprises a reaction chamber 21 for containing a material 22 to be etched, mounted on a table 23, an outlet pipe 24 for exhausting the gas from the chamber 21, attached to the bottom of the chamber 21, the outlet pipe 24 being connected to a vacuum pump (not shown), a first inlet pipe 25 connected to the central top of the chamber 21, for supplying a gas containing fluorine (F) into the chamber 21, a microwave generator 26 for supplying a microwave to a discharge tube 28 via a wave guide 27, the discharge tube 28 being attached to and surrounding a part of the first pipe 25, and a second inlet pipe 30 attached to upper side wall of the chamber 21, for supplying another gas (the second gas) selected from hydrogen (H₂), water vapor (H₂O), steam, an alcohol, and a hydrocarbon.

The gas containing fluorine is introduced into an end 29 of the first pipe 25, and the introduced gas is activated in the discharge tube portion of the first pipe 25 to feed the activated gas into the chamber 21. A carrier gas such as hydrogen is introduced into a container 31 containing a solution such as the water or an alcohol therein through a pipe 32 to bubble in the solution, and the water vapor or the alcohol vapor gas along with the carrier gas are supplied from the container 31 into the chamber 21 through the second pipe 30. The second pipe 30 is provided with a valve 33 for controlling a flowing amount of the gas passing therethrough. The container 31 may be provided with a controller for controlling the temperature of the solution in the container 31.

In this case, when the gas having a low vapor pressure, such as the water vapor, is introduced into the chamber 21, the carrier gas may be effectively used. When the second gas is introduced into the chamber 21 through the second pipe 30, it may be directly introduced- into the second pipe 30 without passing through the container 31.

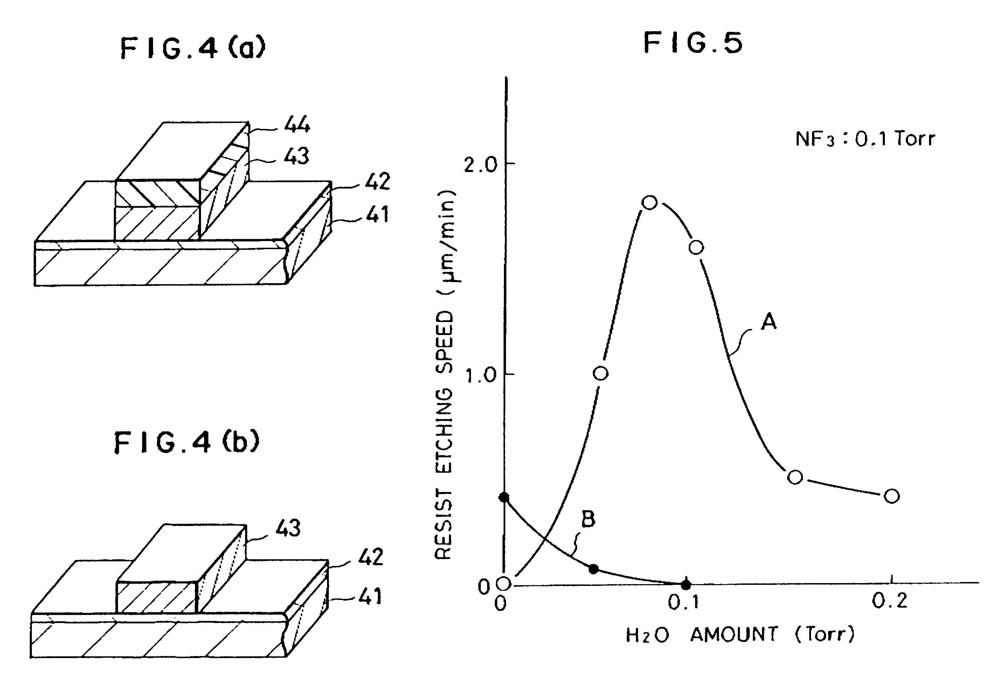

Then, an operation of the apparatus of Fig. 3 will be described. In this embodiment, nitrogen trifluoride (NF₃) and the hydrogen gas are used as the gas containing fluoride (F) and the carrier gas, respectively. In Fig. 4a, there is shown a material 22 to be etched, of which a gate electrode 43 made of a material such as poly-crystalline silicon or aluminum is formed on a semiconductor base plate 41 via a gate oxide film 22 formed thereon using a photoresist pattern film 44 made of an organic compound material as a mask by the reactive ion etching (RIE) in a MOS semiconductor manufacturing process.

The material shown in Fig. 4a is set on the table 23 in the reaction chamber 21. Then, the nitrogen trifluoride (NF₃) gas is introduced into the first pipe 25 through its end 29 and is activated therein by operating the discharge tube 28 to feed fluoride radicals through the first pipe 25 into the chamber 21, and, on the other hand, the hydrogen gas is fed into the chamber 21 along with the water vapor carried on the hydrogen gas through the pipe 32, the container 31 and the second pipe 30. In this embodiment, the flowing amounts of the nitrogen trifluoride gas and the hydrogen gas are determined to a fixed value such as 0.1 Torr, but they may be properly varied depending on the desired practical etching speed and selection ratio so as not to etch the base film under the photoresist or the gate electrode to be etched.

When the material was treated under the conditions described above, the removal of the photoresist was finished in approximately three minutes with a high photoresist removing speed of 7000Å/min. The residues were completely removed, i.e., no residue was produced and found on the gate electrode 43 and the gate oxide film 42 of the finished material 22, as shown in Fig. 4b.

In this embodiment, instead of the hydrogen gas, another carrier gas such as argon (Ar), nitrogen (N₂), oxygen (O₂) or the like may be used, and instead of the water vapor gas and the hydrogen carrier gas, the water vapor gas only, an alcohol such as CH₃OH, C₂H₅OH, or a hydrocarbon such as CH₄, C₂H₆ may be used. Further, instead of the nitrogen trifluoride (NF₃), another gas for generating activated fluorine such as SF₆, CF₄, C₂F₆, C₃F₈, CF₄ + O₂, C₂F₆ + O₂, C₃F₈ + O₂, XeF₂, F₂ or the like, like those used in the chemical dry etching process, may be used.

In this embodiment, when the activated fluorine and the second gas are supplied into the chamber in the same time, the etching speed of the silicon (Si) or the silicon oxide (SiO₂) which is etched when only the fluorine radical is fed, becomes naught, and, in turn, the etching speed of the organic compound film becomes quite faster such as 5000Å/min. It is considered that the fluorine radical reacts with the water vapor gas or the like, and the produced radical such as hydrogen radical, OH radical or HF radical can readily reacts with the organic compound, but does not react with the inorganic compound such as the silicon and the silicon oxide. Therefore, the high organic compound removal can be performed with a very high selection ratio of etching with respect to the inorganic compound such as silicon and silicon oxide.

Fig. 5 shows the photoresist etching speed of the material to be treated in the above described process according to the present invention when the water supply amount is varied. It is readily understood from this characteristics graph that the etching speed of the organic compound photoresist is increased as the water amount is increased to approximately 0.08 Torr, and then is decreased as the water amount is increased further, that the etching speed of the organic compound photoresist is large enough between 0.05 Torr and 0.13 Torr of the water amount, as shown by a curve A, and that the etching speed of the poly-crystalline silicon is reduced as the water amount is increased, and becomes naught when the water amount is at least 0.1 Torr, as shown by a curve B. Accordingly, when the water amount is 0.1 Torr, the ideal photoresist removing characteristics can be obtained in the present process. Hence, it is clear that the addition amount of the second gas is largely related to the organic compound photoresist removing speed, and this addition amount can be properly selected, as shown in Fig. 5.

When the base film is aluminum film, the aluminum film cannot be etched by the fluorine radical, and thus there happens no problem. Further, the fluorine radical has a very long life, and hence may be produced apart from the reaction chamber and then fed therein. In the present method, the second gas to be supplied into the reaction chamber may not be required to activate, and thus the material to be treated is completely separated from the activating device and is not damaged at all thereby in comparison with the oxygen plasma ashing process.

The present invention may be applied to a parallel plate type apparatus, and in such an apparatus, an anode-coupled type or a three electrodes type apparatus may be employed so as to prevent the material to be treated from the attack of high-speed charged particles, thereby preventing the damage of the material.

The present process described above may be utilized in various applications such as a dry cleaning of the surface of the material which is contaminated by an organic compound or the like.

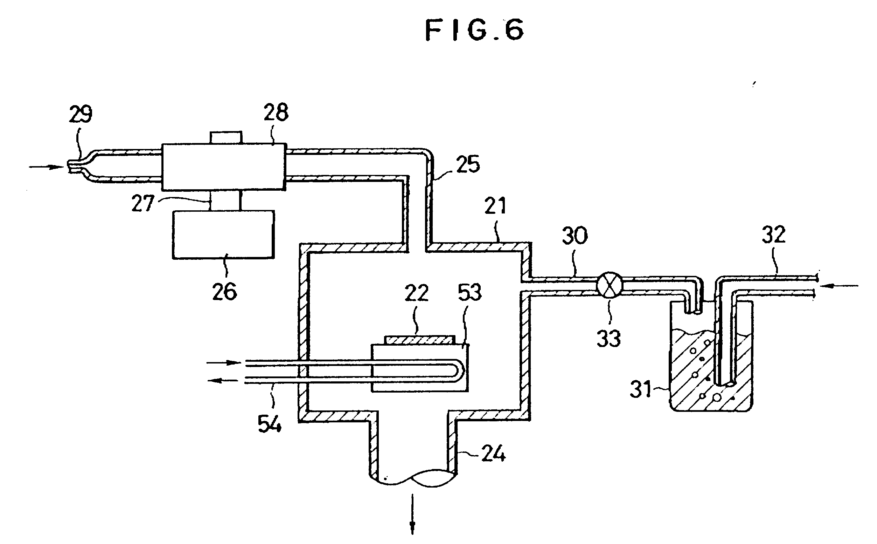

In Fig. 6, there is shown a second embodiment of the apparatus according to the present invention, having the same construction as the embodiment shown in Fig. 3, except that a table 53 for supporting the material 22 to be processed is provided with a cooling device comprising a cooling pipe 54 for cooling the table 53 and thus the material 22 placed on the table 53. A conventional coolant such as the water, ethylene glycol, oils, gases and the like may be used for the cooling device.

In this embodiment, the nitrogen trifluoride (NF₃) gas is introduced as the gas containing fluorine into the first pipe 25 to supply the activated gas into the chamber 21 in the same manner as the first embodiment, and the water in the container 31 is directly introduced into the chamber 21 in the form of the water vapor gas through the second pipe 30 without using any carrier gas. The removal of the photoresist is carried out in the same manner as the first embodiment, as shown in Fig. 4. In this case, the partial pressures of the nitrogen trifluoride gas and the water vapor are determined to a fixed value such as 0.1 Torr, but they may be properly changed depending on the desired practical etching speed and selection ratio so as not to etch the base film under the photoresist or the gate electrode to be etched.

The removal of the photoresist will be conducted under these conditions after the gate electrode made of aluminum or aluminum compound is etched using the photoresist (OFPR 800, Trade Name of Tokyo Applied chemical company) as the mask in the reactive ion etching process. When this photoresist removal is carried out without cooling the material 22, the photoresist temperature rises more than 100°C in approximately one minute after the reaction gases are introduced into the chamber and the ashing of the photoresist is started. In approximately one minute initial processing, almost all photoresist can be removed, but the residues are produced on the aluminum electrode and the oxide film, as described hereinbefore in the conventional process in connection with Fig. 1. In order to completely remove the residues, at least five minutes treating time is required.

According to the present invention, the table 53 is cooled to keep the temperature of the material 22 to approximately 0°C during the ashing of the photoresist, the photoresist can be completely removed in approximately three minutes without producing any residue on the electrode and the oxide film. This processing time is reduced to half in comparison with the treatment without cooling. In this embodiment, of course, the same effects and advantages as those resulted in the first embodiment described above can be obtained.

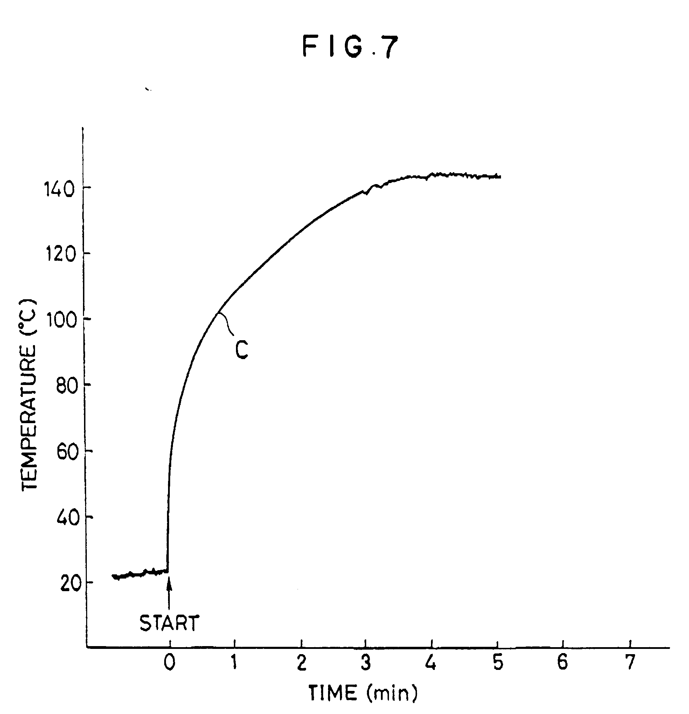

Fig. 7 shows a curve C representing the relation between the photoresist temperature and the processing time, and it is found that as the ashing proceeds, the photoresist temperature is raised more than 150°C in five minutes, and the photoresist temperature rise causes an important factor for producing the residues on the material during the ashing.

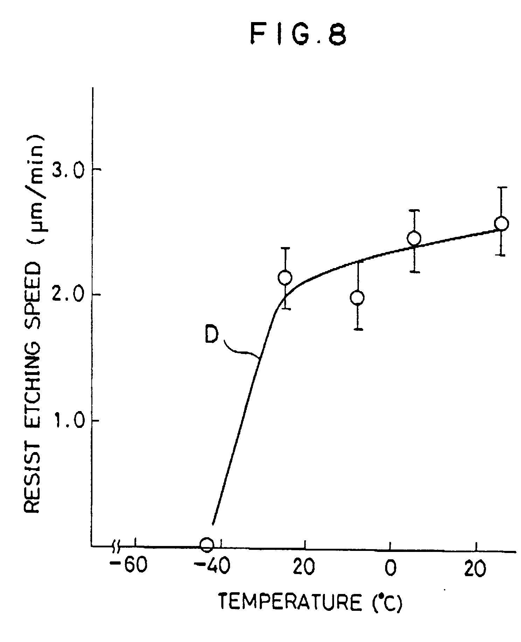

However, in the ashing process using the halogen radical such as fluorine radical, the photoresist temperature rise is not essential, the ashing can proceed at low temperature. Fig. 8 schematically illustrates a curve D which represents the relation between the photoresist etching speed and the temperature of the material to be treated in the plasma ashing process using nitrogen trifluoride (NF₃) and the water vapor gas (H₂O) which are separately introduced into the reaction chamber, as described above. From Fig. 8, it is apparent that the practically quick etching speed may be obtained even when the temperature of the material is lowered under the room temperature. In Fig. 8, the ashing speed is rapidly fallen to the naught under -40°C, and this is caused by the dew condensation of the water on the material.

In this embodiment, by using the carrier gas set forth in the first embodiment described above, the same effects and advantages can be obtained. Further, other gases aforementioned in the first embodiment may be used as the gas containing fluorine, and hydrogen, a hydrocarbon and an alcohol, aforementioned in the first embodiment, may be also used instead of the water vapor gas.

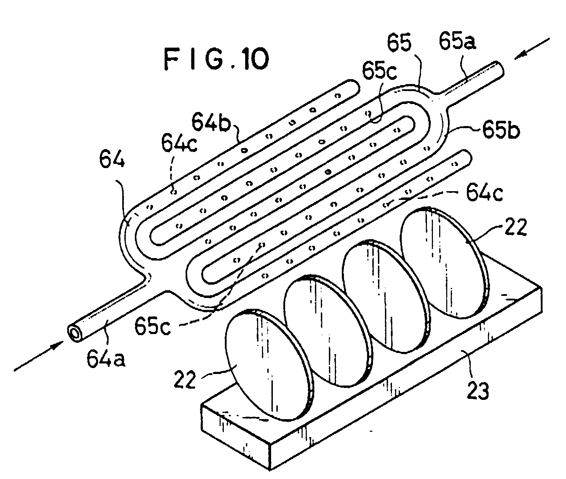

In Fig. 10, there are shown a first embodiment of first and second nozzles 64 and 65 for supplying the gases to a plurality of materials 22 such as wafers or the like, mounted on the table 23, for use in the apparatuses shown in Figs. 3 and 6.

In the drawing, the first nozzle 64 includes a main tube 64a and three branch tubes 64b with openings 64c facing downwards, through which the gas is supplied toward the materials 22. The second nozzle 65 includes a main tube 65a and two branch tubes 65b with openings 65c facing downwards, through which the gas is supplied toward the materials 22. The main tubes 64a and 65a of the first and second nozzles 64 and 65 may be connected to the first and second pipes 25 and 30 of the apparatuses shown in Figs. 3 and 6. For instance, the activated gas containing fluorine is supplied to the first nozzle 64, and another gas such as the water vapor, the hydrogen gas, the gas containing at least hydrogen or the gas containing at least oxygen is supplied to the second nozzle 65.

The branch tubes 64b of the first nozzle 64 and the branch tubes 65b of the second nozzle 65 are alternately arranged in parallel with one another in order to well mix the gases supplied from the openings of the branch tubes 64b and 65b and to uniformly apply the well-mixed gases toward the materials 22. Accordingly, the gases supplied from the different tubes 64 and 65 are mixed well, and the well-mixed gases are evenly applied toward the materials 22 to be etched, resulting in performing the uniform etching or ashing of the materials.

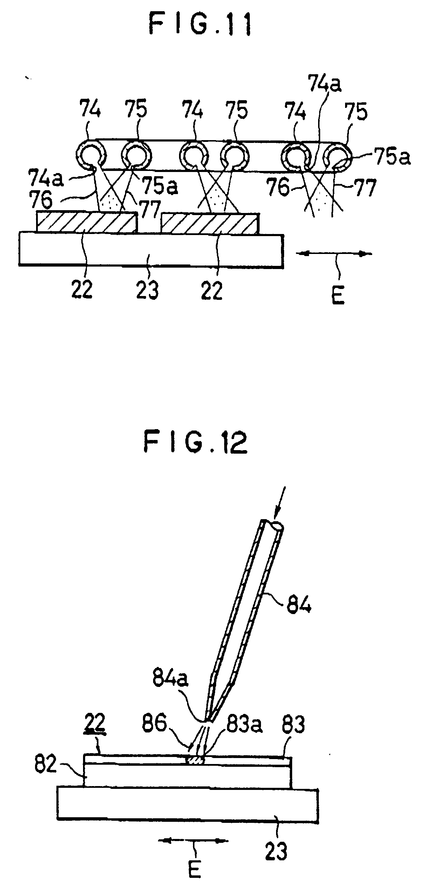

In Fig. 11, there are shown a second embodiment of first and second nozzles 74 and 75 having the similar constructions to those of the first embodiment shown in Fig. 10, for use in the same manner as the first embodiment. The first and second nozzles 74 and 75 including respective openings 74a and 75a for discharging the gases are alternately arranged in parallel with one another in the similar manner to the first embodiment of Fig. 10. The openings 74a and 75a of the adjacent first and second nozzles 74 and 75 are designed to open somewhat inside directions at a certain angles so as to well and uniformly mix the different gases discharged from the openings 74a and 75a.

In this case, the table 23 for supporting the materials 22 to be processed may be movable with respect to the first and second nozzles 74 and 75 thereunder in a plane parallel with the plane where the first and second nozzles 74 and 75 are arranged, as indicated by an arrow E in Fig. 11, using a drive means such as a motor (not shown), in order to uniformly apply the well-mixed gas toward the materials 22. Hence, in this case, the concentration of the supplied gases may be partially raised, and, since the materials 22 are moved relative to the openings 74a and 75a of the first and second nozzles 74 and 75 so as to apply the mixed gas to the entire surfaces of the materials 22, the uniform and quick etching can be performed.

In Fig. 12, there is shown a third embodiment of a nozzle 84 having a small opening 84a in its lower end, and the table 23 for supporting the material 22 which comprises a semiconductor base plate 82 and an organic compound film 83 formed thereon. The nozzle 84 is somewhat inclined with respect to the vertical line perpendicular to the surface of the material 22, and the table 23 is movable in the same manner as the one shown in Fig. 11, as indicated by the arrow E in Fig. 12. In this case, one of the two kinds of gases is firstly fulfilled in the chamber 21, and then the other gas 86 is supplied from the small opening 84a of the nozzle 84 toward a small portion 83a to be treated of the organic compound film 83, thereby partially etching a small area of the material 22. When the table 23 is moved during the etching of the material 22, the material 22 can be treated in a linear form.

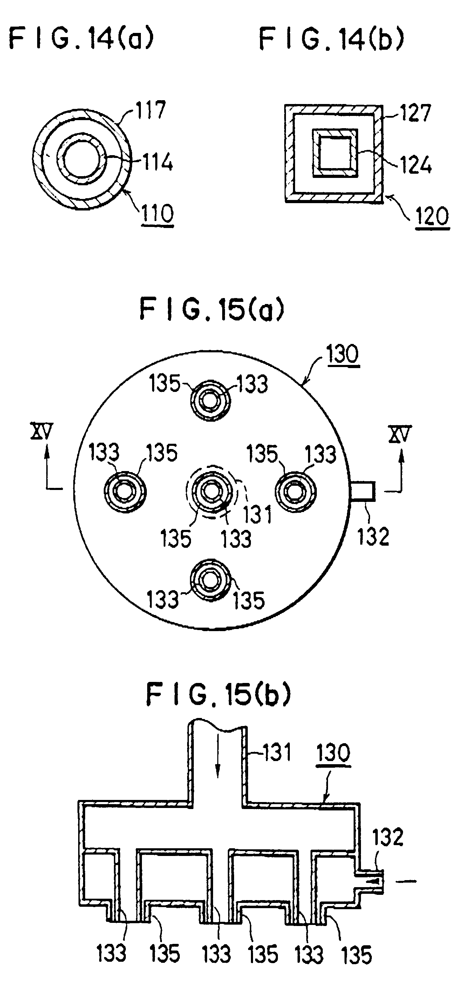

In Fig. 13, there is shown a fourth embodiment of a double tube nozzle, for example, made of quartz, which comprises an inner tube 93 having an opening 94 and an outer tube 96 having an annular opening 97, the outer tube 96 concentrically surrounding the inner tube 93. The end portion of outer tube 96 is tapered off. This double tube nozzle may be arranged within the chamber 21 of Figs. 3 and 6. The inner tube 93 is connected to the first pipe 91 through the discharge tube 28, and the outer tube 96 is coupled to the second pipe 95. The gases are supplied toward the material 22 mounted on the table 23 from the openings 94 and 97 of the inner and outer tubes 93 and 96 through the first and second pipes 91 and 95.

In Fig. 14, there are shown two cross sections of two embodiments of the end portion of the double tube nozzle shown in Fig. 13. As shown in Fig. 14a, the end portion 110 of the nozzle comprises inner and outer concentric circular tubes 114 and 117. As shown in Fig. 14b, the end portion 120 of the nozzle comprises inner and outer concentric square tubes 124 and 127. In this case, by using these nozzles, the gases can be uniformly applied to the material 22, which is advantageous and convenient.

When the gas containing fluorine is fed to the inner tube 114 or 124 and the second gas is supplied to the outer tube 117 or 127, the gas containing the fluorine does not readily affect or attach to the unrelated portions such as the wall of the chamber 21 other than the material 22. In turn, the gas containing the fluorine can be effectively applied to the desired portion such as the organic compound film of the material 22, resulting in improving the photoresist removing or etching efficiency.

Further, by properly selecting the flowing amounts or the flowing speeds of the gases, the gas containing the fluorine may be supplied to the outer tube 117 or 127 and the second gas may be fed to the inner tube 114 or 124.

Fig. 15 shows a fifth embodiment of a nozzle or nozzle unit 130 made of quartz, including a plurality of double tube nozzles similar to the nozzle 110 shown in Fig. 14a. Fig. 15a is an elevational view of the nozzle 130 and Fig. 15b is a longitudinal cross sectional view, taken along the line of XV - XV in Fig. 15a. The nozzle unit 130 comprises five double concentric circular tube nozzles, each nozzle comprising an inner tube 133 and an outer tube 135, a first pipe 131 connected to the inner tubes 133, and a second pipe 132 connected to the outer tubes 135. The gases are introduced into the first and second pipes 131 and 132 in the same manner as the fourth embodiment shown in Fig. 13. By using this nozzle unit 130, the material 22 such as a wafer having a large surface area can be effectively and uniformly treated. For instance, when 5 inches of wafers were processed using this nozzle unit 130 while the carbon tetrafluoride (CF₄) was fed to the nozzle unit 130, the organic compound photoresist formed on the surfaces of the wafers was removed at the etching speed of more than 7000Å/min on the surfaces of the wafers without producing any residue thereon.

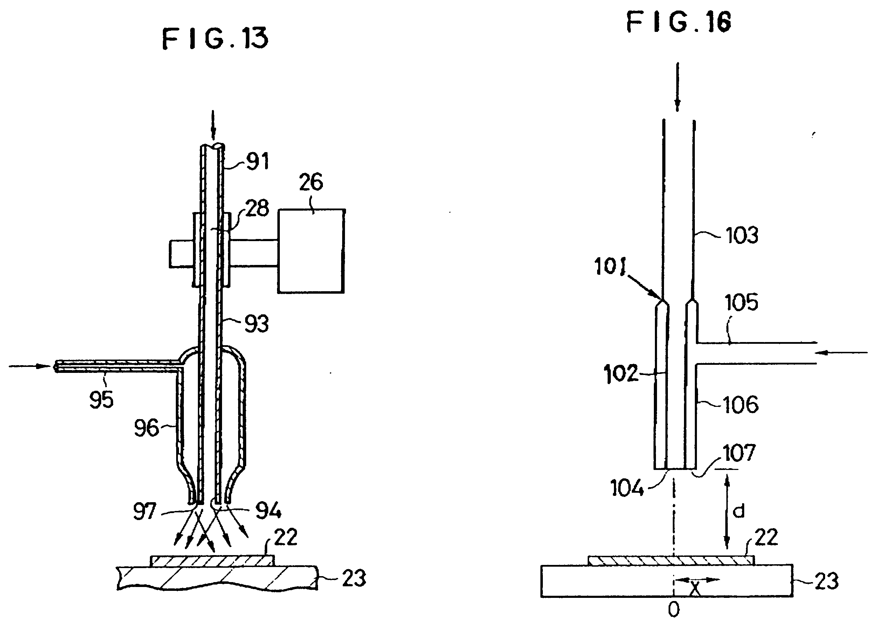

In Fig. 16, there is shown sixth embodiment of a nozzle 101 of the double concentric circular tube type, which comprises an inner tube 102 having an opening 104 in its lower end, connected to a first pipe 103, and an outer tube 106 having an annular opening 107 in its lower end, connected to a second pipe 105. In this case, for example, the gas containing the fluorine is supplied to the first pipe 103, and the second gas is fed to the second pipes 105 in the same manner as the above embodiments to feed the gases from the openings 104 and 107 of the inner and outer tubes 102 and 106 toward the material 22 mounted on the table 23. The nozzle 101 is vertically arranged above the flattened material 22 to be treated at a distance d apart from the material 22, and the central axis of the nozzle 101 passes through the center O of the material 22.

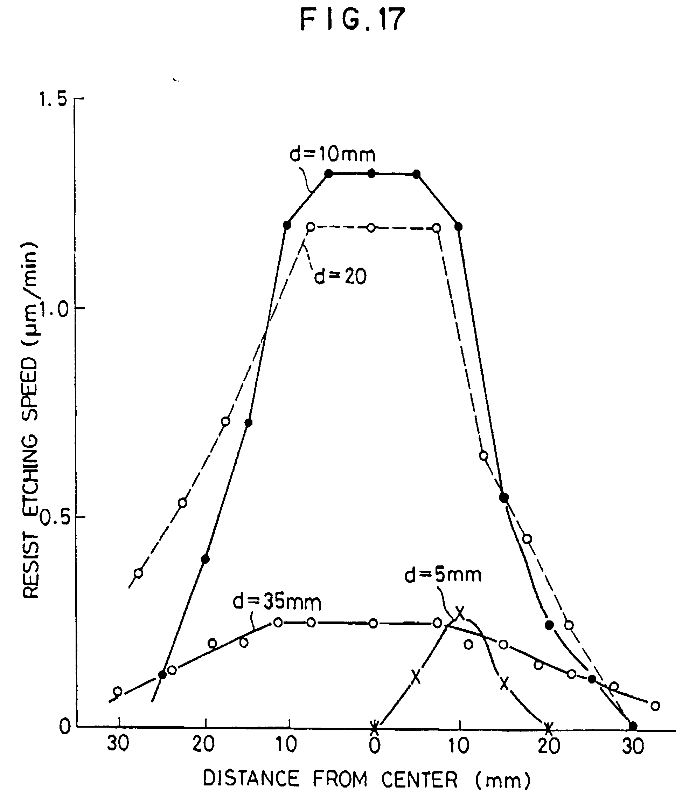

For example, the etching of the photoresist of the material 22 was carried out by feeding the nitrogen trifluoride (NF₃) with its flowing amount or pressure of 30 sccm and the water vapor or gas (H₂O) with its flowing amount or pressure of 0.075 Torr (total pressure of 0.15 Torr) into the inner and outer tubes 102 and 106, respectively, to obtain four curves representing a relation between a photoresist etching speed and a distance x away from the center O of the material 22 while the distance d between the surface of the material 22 and the opening end 104 and 107 of the nozzle 101 is varied to 5 mm, 10 mm, 20 mm and 35 mm, as shown in Fig. 17. In this embodiment, the diameter of the inside wall of the inner tube 102 was approximately 6 mm, and the diameters of the inner and outer inside walls of the outer tube 106 are approximately 8 mm and 10 mm, respectively.

It is readily understood from Fig. 17 that, when the distances d between the material 22 and the opening end of the nozzle 101 are 10 mm and 20 mm, the photoresist can be etched at a quick etching speed, in practice, but, when the distances d between the material 22 and the opening end of the nozzle 101 are 5 mm and 35 mm, not so quick etching speed can be obtained, and that the photoresist etching can be effectively performed within approximately 10 mm apart from the center O of the material 22. It is considered from this example that, when the distance d is 5 mm, the two gases discharged from the openings 104 and 107 of the inner and outer tubes 102 and 106 are not mixed so well, and that, when the distances d is 35 mm, the most activated radicals die a natural death or lose the activities until they reach the material 22.

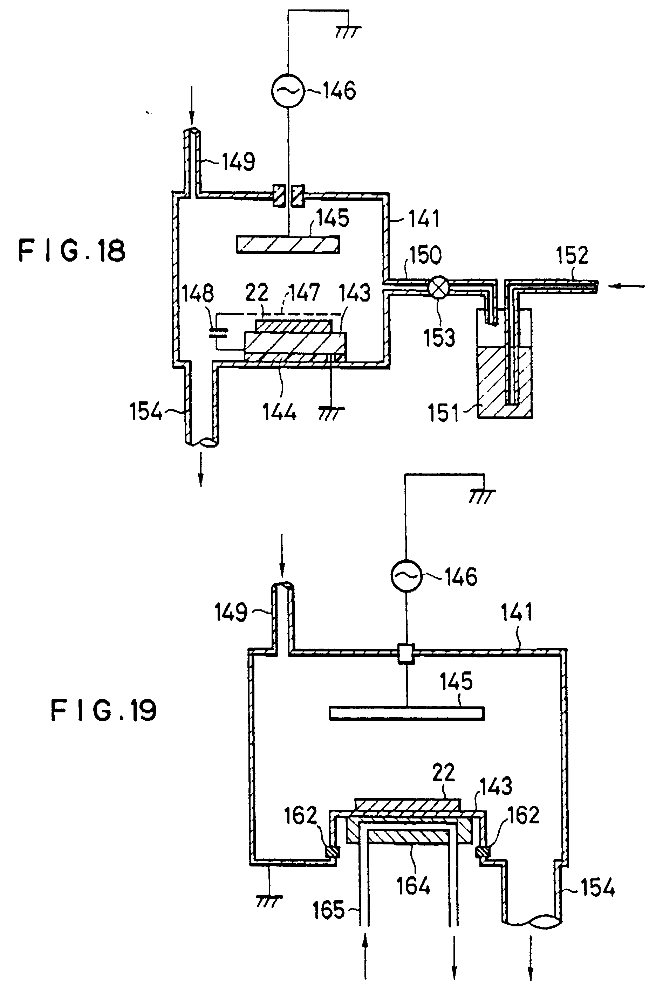

In Fig. 18, there is shown a fourth embodiment of the apparatus according to the present invention, which is of a parallel plate type dry etching apparatus. A reaction chamber 141 contains a material 22 mounted on an anode electrode plate 142 which is secured to the bottom of the chamber 341 via an insulating material 144, and a cathode electrode plate 145 is arranged above the anode electrode plate 143 in parallel thereto in the chamber 145. An electric power source 146 for generating a high frequency wave is connected between the two anode and cathode electrodes 143 and 145 of the parallel plate type to generate an electric discharge therebetween for placing the material in the plasma produced by the discharge.

In this embodiment, the quick etching can be carried out, and thus the electric discharge may be generated in a small intensity in order to prevent the damage on the material 22. Hence, for example, the material 22 having the organic compound film thereon is preferably mounted on the anode electrode plate 143, or the power to be supplied between the two electrodes 143 and 145 may be reduced. Alternatively, a mesh 147 which is made of a metallic material such as aluminum, nickel, platinum or the like and is electrically connected to the anode electrode 143 via a battery 148, may be arranged between the two electrodes 143 and 145 so as to cover the surface of the material 22, as shown in Fig. 18, thereby completely preventing the damage onto the material during the discharge.

The chamber 141 is provided with a first inlet pipe 149 for supplying the activated gas containing fluorine radicals on the top wall, a second inlet pipe 150 for feeding the second gas, through another pipe 152 and a container 151 containing the water on one side wall, and an outlet pipe 154 to be connected to a vacuum pump, for discharging the gases from the chamber 141 on the bottom. In this case, the etching of the material 22 is performed while the electric charge is generated between the two electrodes 143 and 145, with a result of a quick removal of the organic compound film of the material 22.

In Fig. 19, there is shown a fifth embodiment of a parallel plate type apparatus according to the present invention, having the same construction as the embodiment shown in Fig. 18, except that a support member 164 for supporting the anode electrode 143 is provided with a cooling device including a cooling pipe 165 for cooling the anode electrode 143 and thus the material 22 mounted thereon, and the second inlet pipe of the fourth embodiment is omitted.

Although, in general, the gas containing fluorine is added to the basic gas such as the oxygen, the fluorocarbon resin may be used for generating the fluorine radicals by activating the resin placed in the plasma.

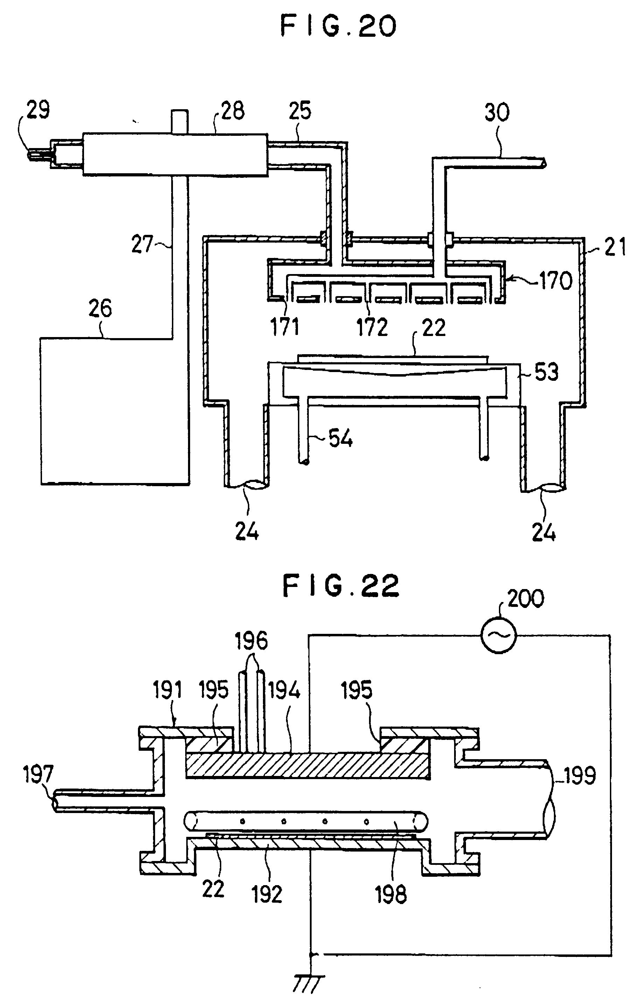

In Fig. 20, there is shown a sixth embodiment of the apparatus according to the present invention, which is capable of performing a dry etching process. The construction of this apparatus is basically the same as the one of the second embodiment described above in connection with Fig. 6, and thus the description of the same members can be omitted for the brevity. In this case, a nozzle unit 170 is secured to the upper wall of the chamber 21 and is provided with a plurality of double concentric tube type nozzles which includes outer tubes having openings 171 and inner tubes having openings 172. The outer and inner tubes of the nozzle unit 170 are connected to the first and second pipes 25 and 30, respectively. A pair of outlet pipes 24 are connected to right and left sides of the bottom of the chamber 21. The gases are introduced into the chamber 21 through the first and second pipes 25 and 30 and the outer and inner openings 171 and 172 of the outer and inner tubes of the nozzle unit 170 in the same manner as the above described embodiments.

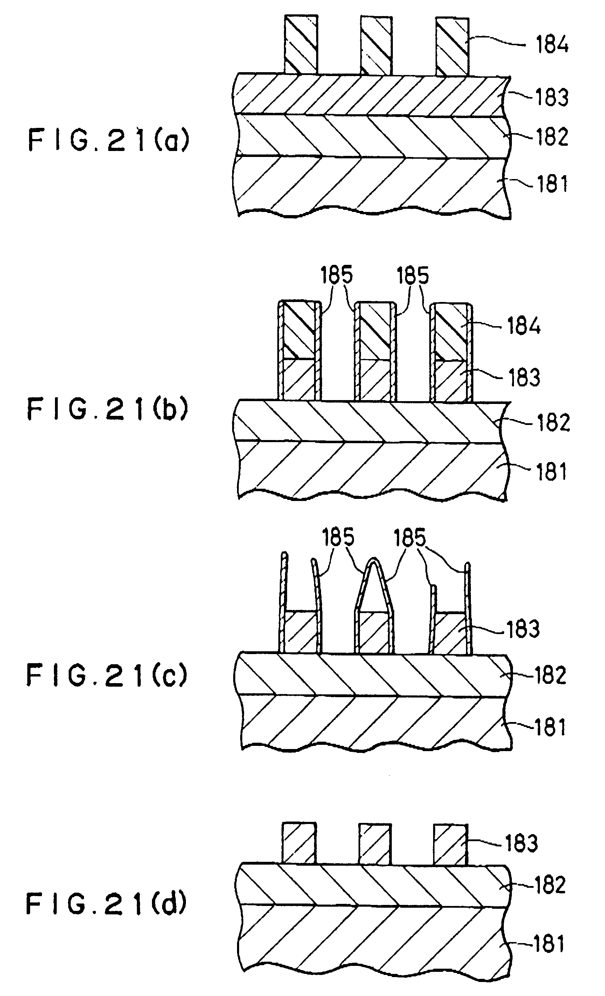

Fig. 21 schematically shows an etching process of the material 22 using the apparatus shown in Fig. 20. First, a silicon oxide film 182 having a thickness of approximately 0.8 micrometer is formed on a P-type silicon base plate 181 by a wet oxidization process or the like, and then an aluminum film 183 having a thickness of approximately 0.8 micrometer is formed on the silicon oxide film 182 by the sputtering or the like. Then, a positive photoresist film pattern 184 is formed on the aluminum film 183 in the conventional manner, to obtain the material 22 shown in Fig. 21a.

Then, the aluminum film 183 of the material 22 of Fig. 21a is etched using the photoresist film pattern 184 as the mask in an anisotropic etching such as the reactive ion etching. During the etching process, film walls 185 are formed on the side walls of the photoresist film pattern 184 and the patterned aluminum film 183, as shown in Fig. 21b.

After the analysis of the film walls 185 formed on the material 22 during the etching process, it is found that the film walls 185 comprises ingredients of aluminum, carbon and silicon. It is considered that concerning the aluminum, the aluminum sputtered from the aluminum film 183 of the material 22 attaches again on the material, that as to the silicon, the aluminum film 183 is, in fact, a silicon alloy containing approximately 1% of silicon or the silicon oxide film 182 under the aluminum film 183 is sputtered and is mixed into the film walls 185, and that relating the carbon, it is produced by the decomposition of the organic compound photoresist 184 and is mixed into the film walls 185.

Firstly, when the removal of the photoresist film 184 of the material 22 shown in Fig. 21b was performed using a conventional oxygen dry plasma ashing apparatus, and the finished material was observed by using a scanning electron microscope (SEM) to find that the film walls 185 could not be removed, as shown in Fig. 21c.

Next, the material 22 of Fig. 21b was treated using the apparatus shown in Fig. 20 as follows. First, the mixture gas of the Freon-14 (Trade Name) containing the carbon tetrafluoride (CF₄) and the oxygen (O₂) gas was introduced into the first pipe 25 to keep its pressure to approximately 0.2 Torr, and the microwave power source 26 is operated to apply a 200W of microwave to the discharge tube 28 in order to generate the electric discharge for activating the gas in the first pipe 25. Since the formed fluorine radicals have a quite long life, they can be fed into the chamber 21 as they are alive. This step is continued for approximately five minutes for removing the silicon. Then, the nitrogen trifluoride (NF₃) was introduced into the first pipe 25 to keep its pressure to approximately 0.2 Torr, and the microwave power source 26 is operated to apply the 200W of microwave to the discharge tube 28 in the same manner as the previous step. In the same time, the water vapor (H₂O) was introduced into the second pipe 30 for producing the oxygen radicals. The ratio between the two gases was determined to 1:1. This step is continued for approximately three minutes. Lastly, the chlorine (Cl₂) gas was introduced into the first pipe 25 to keep its pressure to approximately 0.2 Torr, and the microwave power source 26 is operated to apply the 200W of microwave to the discharge tube 28 in the same manner as the previous step in order to supply the activated chlorine radicals into the chamber 21. Then, the treated material 22 is taken out of the chamber 21 and is observed using the SEM to find that the photoresist 184 and the film walls 185 of the material 22 could be completely and clearly removed without producing any residue, as shown in Fig. 21d.

In this embodiment, the order of the first and second steps may be changeable, and boron trifluoride (BF₃), perfluoroethane (C₂F₆), perfluoropropane (C₃F₈), xenon difluoride (XeF₂), sulfur hexafluoride (SF₆) or the like can be, of course, used as the gas containing fluorines. It has been confirmed that in the third step, any gases for generating chlorine radical such as carbon tetrachloride (CCl₄), boron trichloride (BCl₃), phosphorus trichloride (PCl₃) or the like may be used in principle.

In general, when the material 22 is processed by the gas containing the activated fluorine, the gas containing the activated oxygen and the gas containing the activated chlorine, the effects and advantages of the present invention can be obtained. However, as to the aluminum, since the aluminum is oxidized by the oxygen in the air to become alumina, the aluminum can not be readily removed by the chlorine radical. Therefore, it becomes important to determine the order of the treatments using the radicals. That is, when the silicon is firstly removed from the material 22 by the fluorine radical and then the photoresist and the carbon are ashed by the oxygen radical, since the silicon and the carbon in the film are removed, the films to be removed become fragile and weak. The remained aluminum becomes in the form of a continuous connection of islands, as formed in the initial step of the film coating process, and the surface area of the aluminum is highly enlarged, i.e., the aluminum becomes extremely active. Thus, the remained aluminum may be readily removed by the chlorine radical. Accordingly, the photoresist removing process is preferably performed in the order described above. Further, other specimens of the material 22, prepared by forming the film using molybdenum, tungsten, titanium or siliside thereof instead of the aluminum film 183, can be effectively treated in the same manner as described above, with the result of the same effects and advantages as those of the aluminum film.

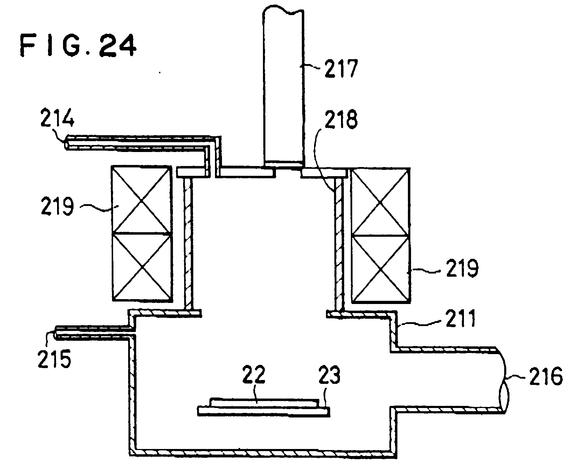

In Fig. 22, there is shown a seventh embodiment of the apparatus according to the present invention, i.e., a anode-coupled type parallel plate etching apparatus. In this embodiment, a reaction chamber 191 is provided with first and second inlet pipes 197 and 198 and an outlet pipe 199 to be connected to a vacuum pump (not shown). In the reaction chamber 191, the material 22 to be treated is mounted on a grounding anode electrode 192 constituting the bottom of the chambr 191, and a cathode electrode 194 is arranged as an upper wall in the upper portion of the chamber 191 via insulating members 195. A cooling tube 196 is mounted in the cathode electrode 194. A high frequency power source 200 is connected between the two electrodes 192 and 194.

The photoresist removing operation is conducted as follows. Firstly, the mixture gas of the Freon-14 and the oxygen gas was introduced into the chamber 191 through the inlet pipe 197 or 198 to keep the gas pressure to approximately 0.5 Torr, and the high frequency power source 200 was operated to apply the 0.5W/cm² of high frequency power between the two electrodes 192 and 194 to generate the plasma in the chamber 191. Then, the mixture gas was discharged from the chamber 191. The oxygen gas was introduced into the chamber 191 to keep the pressure to approximately one Torr, and by operating the power source 200, the 1W/cm² of high frequency power was applied between the two electrodes 192 and 194 to generate the plasma in the chamber 191. this step was continued for 10 minutes. Lastly, the chlorine gas was introduced into the chamber 191 to keep the pressure to approximately 0.4 Torr, and the 0.5W/cm² of high frequency power was applied between the two electrodes 192 and 194 to generate the plasma in the chamber 191 in the same manner as the previous step. After processing the material 22, it was taken out and was observed using the SEM to find that the photoresist and the film walls could be completely and clearly removed, as shown in Fig. 21d, with the result of the same effects and advantages as those obtained in the sixth embodiment of the apparatus.

In Fig. 24, there is shown a ninth embodiment of the apparatus according to the present invention, which is a dry plasma processing apparatus using the electron cyclotron resonance discharge. In this case, a reaction chamber 211, in which the material 22 to be processed is mounted on the table 23, is formed with two inlet pipes 214 and 215 on its upper and intermediate portions and an outlet pipe 216 on its lower portion. The chamber 211 includes a discharge tube 218 made of quartz in its upper half portion and magnets 219 arranged outside of the discharge tube 218. When a microwave of 2.45 GHz is applied from a generator (not shown) to the discharge tube 218 through a wave guide 217 and the magnets 219 generate 875 gauss of magnetic field in the discharge tube 218, electrons resonate with the microwave to conduct the cycloid movement, as a result generating the dense plasma in the discharge tube 218.

In general, in the apparatus of this kind, the etching is practiced at a low pressure of approximately 0.0001 Torr. However, when the apparatus is operated at a high pressure, a large amount of radicals can be generated and the etching can be effectively performed. The photoresist and the film walls of the material 22 can be completely and clearly removed in the same manner as the embodiments shown in Figs. 20, 22 and 23.

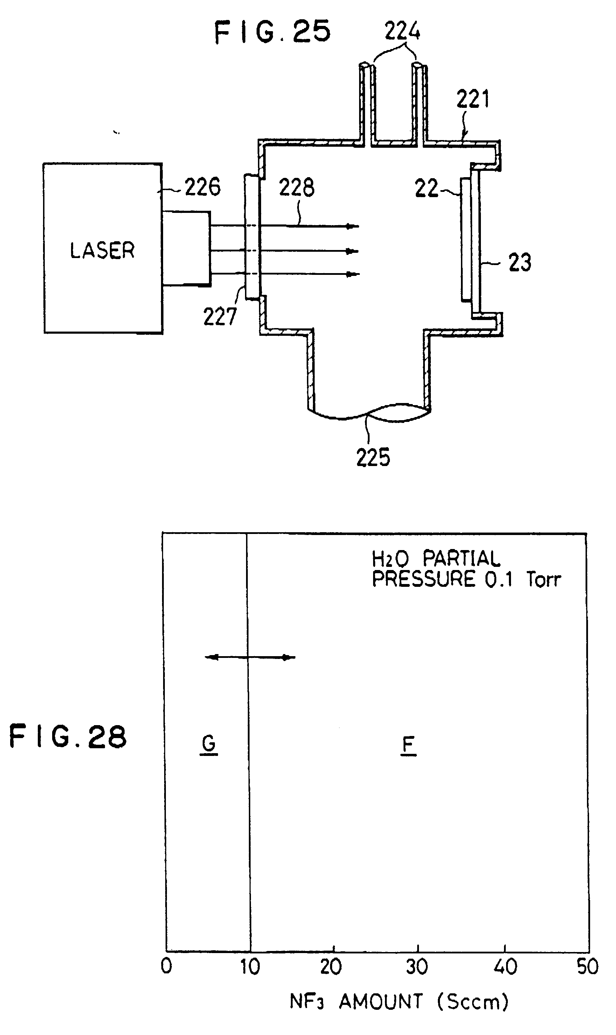

In Fig. 25, there is shown a tenth embodiment of the apparatus according to the present invention, which is a dry etching apparatus utilizing radicals generated by using luminous energy. In this embodiment, a vacuum reaction chamber 221 is provided with the table 23 on one side wall for supporting the material 22 to be treated, inlet pipes 224 on the top wall, an outlet pipe 225 on the bottom, and a window 227 on the opposite side wall for introducing the light beam 228 generated by a laser generator 226.

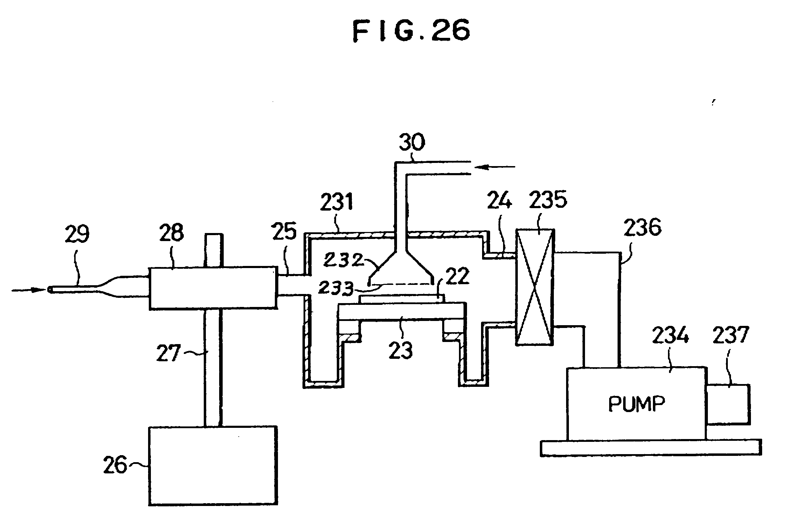

There is shown in Fig. 26 an eleventh embodiment of the apparatus according to the present invention, having a similar construction to the ones of the embodiments shown in Figs. 3, 6, 9 and 20. In this embodiment, the first inlet pipe 25 is coupled to one side wall of a reaction chamber 231 and a second inlet pipe 30 is connected to the central portion of the top wall of the chamber 231 and is linked to a nozzle 232 having a plurality of openings 233 open right above the material 22 mounted on the table 23. The outlet pipe 24 is mounted to another side wall opposite the first inlet pipe 25 and an oil rotary pump 234 having an exhaust pipe 237 for exhausting the gas from the chamber 231 is connected to the outlet pipe 24 via a valve 235 and a duct 236.

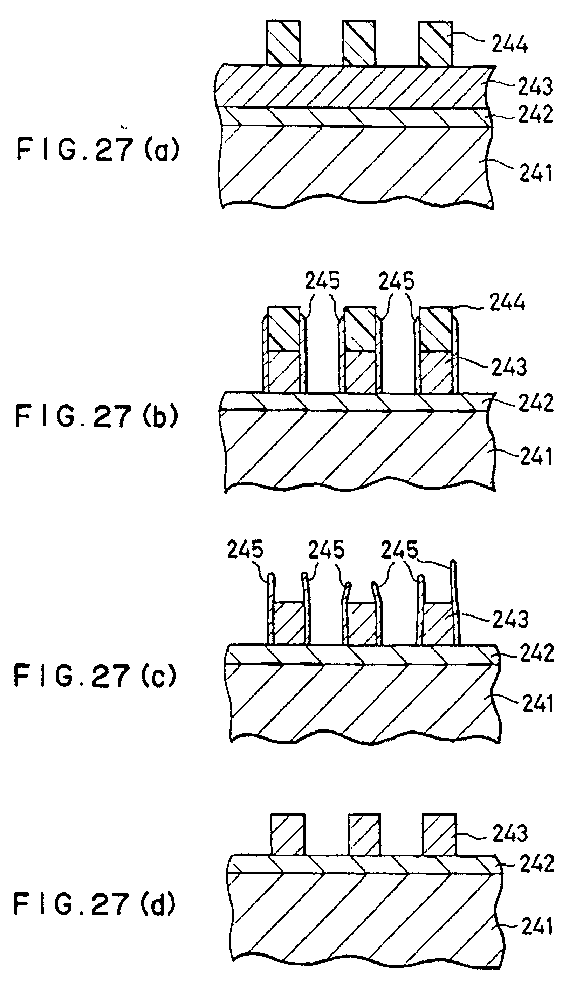

Fig. 27 schematically shows an etching process of the material 22 using the apparatus shown in Fig. 26. A silicon oxide film 242 having a thickness of approximately 100Å is formed on a silicon base plate 241, and then a poly-crystalline silicon film 243 is formed on the silicon oxide film 242 in the conventional way. Then, a photoresist film pattern 244 is formed on the poly-crystalline silicon film 243 in a conventional manner, to obtain the material 22 shown in Fig. 27a. Then, the poly-crystalline silicon film 243 of the material 22 of Fig. 27a is etched using the photoresist film pattern 244 as the mask in the reactive ion etching process. During the etching process, film walls 245 are formed on the side walls of the photoresist film pattern 244 and the patterned poly-crystalline silicon film 243, as shown in Fig. 27b. Then, the material of Fig. 27b is set on the table 23 in the chamber 231 shown in Fig. 26, and is treated therein.

In Fig. 26, the gas containing nitrogen trifluoride (NF₃) and the water vapor (H₂O) were introduced into the chamber 231 through the first and second inlet pipes 25 and 30, respectively, and the photoresist removing was conducted in the same way as described above. First, when the photoresist removing treatment was performed using the oxygen plasma ashing apparatus, the film walls 245 were not removed, as shown in Fig. 27c. Next, when the photoresist removing treatment was conducted as described above according to the present invention, the photoresist 244 and the film walls 245 could be completely and clearly removed, as shown in Fig. 27d.

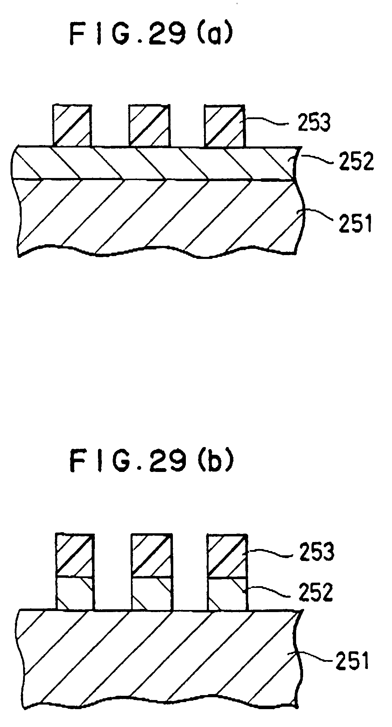

Fig. 28 shows the relation between the flowing amount (sccm) of the nitrogen trifluoride (NF₃) with respect to the fixed partial pressure 0.1 Torr of the water vapor (H₂O) and the removable and unremovable areas F and G of the material 22 in the above described embodiment of Fig. 26. When the flowing amount of the nitrogen trifluoride is small, the film walls 245 of the material 22 cannot be removed, but, when the flowing amount of the nitrogen trifluoride is sufficient, the film walls 245 of the material 22 can be completely removed. In this case, it is considered that the nitrogen trichloride is activated by the microwave discharge to generate the fluorine radical, and the fluorine radical reacts with the water to generate the oxygen radical, and that the fluorine radical and the oxygen radical affect the material 22 in the same time, which is important for removing the film walls 245 of the material 22. In this embodiment, the gas for generating the fluorine radical by the electric discharge, such as sulfur hexafluoride (SF₆), carbon tetrafluoride (CF₄), boron trifluoride (BF₃), phosphorus trifluoride (PF₃), phosphorous pentafluoride (PF₅) or the like, may be also used in the same manner as nitrogen trifluoride (NF₃) with the same effects and advantages. Further, instead of the water vapor (H₂O) alcohols such as methyl alcohol (CH₃OH), ethyl alcohol (C₂H₅OH) and the like may be used with the same effects and advantages.

Fig. 29 schematically shows another etching process of the material 22 using apparatus shown in Fig. 26. A silicon oxide film 252 having a thickness of approximately one micrometer is formed on a silicon base plate 251 by heating the base plate 251 at approximately 1000°C, and then a photoresist film pattern 253 is formed on the silicon oxide film 251 in a conventional manner, as shown in Fig. 29a. Then, the silicon oxide film 252 is etched using the photoresist film pattern 253 as the mask by supplying carbon tetrafluoride (CF₄) and the hydrogen gas (H₂) in the reactive ion etching process. During the etching process, film walls are formed on the side walls of the photoresist film pattern and the patterned silicon oxide film 252 in the same way as described above in connection with Fig. 27.

Then, when the photoresist removal of the material 22 is conducted in the oxygen plasma ashing process, the film walls could not be removed. When the photoresist removing treatment of the material 22 is carried out in the chamber 231 of Fig. 26 using the nitrogen trifluoride (NF₃) and the water vapor (H₂O) in the same manner as described above according to the present method, the photoresist 253 and the film walls could be completely and clearly removed, as shown in Fig. 29b.

In this embodiment, when it is difficult to feed the water vapor (H₂O) into the chamber, the carrier gas such as hydrogen (H₂), nitrogen (N₂) or oxygen (O₂) may be used with the same effects and advantages. Further, this embodiment is not restricted to the treatment of the poly-crystalline silicon film and the silicon oxide film, and may be applied to other materials such as silicon nitride film, molybdenum, tungsten, titanium, tantalum, hafnium and siliside thereof film and the like.

Although the present invention has been described in its preferred embodiments with reference to the accompanying drawings, it is readily understood that the present invention is not restricted to the preferred embodiments and that various changes and modifications may be made in the present invention by a person skilled in the art without departing from the spirit and scope of the present invention.

## Claims

1. A method for removing a film from the surface of a substrate located in a chamber by dry plasma etching comprising the steps of:
generating fluorine radicals outside the chamber from a fluorine-containing gas; and
separately feeding the fluorine radicals and a second gas selected from hydrogen, water, an alcohol and a hydrocarbon into the chamber where they react to form radicals for performing the dry plasma etching.

2. A method according to Claim 1, characteiized in that said surface is made of a metallic material.

3. A method according to Claim 2, characterized in that said metal material comprises aluminium or an aluminium alloy.

4. A method according to Claim 3, characterized in that said surface comprises a film of aluminium or an aluminium alloy formed on a surface of a substrate.

5. A method according to Claim 4, characterized in that the surface of said substrate comprises silicon or a silicon compound.

6. A method according to Claim 5, characterized in that said silicon compound is silicon oxide.

7. A method according to Claim 6, characterized in that a silicon semiconductor is coated with a silicon oxide film on which said film is formed.

8. A method according to Claim 1, characterized in that the hydrogen, water, alcohol or hydrocarbon is introduced into said chamber together with a carrier gas.

9. A method according to Claim 10, characterized in that said carrier gas is oxygen or argon.

10. A method according to Claim 8, characterized in that said carrier gas is bubbled through a solution including water or an alcohol and introduced into said chamber in order to transport water or said alcohol in a fluid form.

11. A method according to Claim 8, characterized in that said fluorine radicals are generated by activating a gas selected from the group consisting of SF₆, NF₃, CF₄, C₂F₆, C₃F₈, SF₆+O₂, NF₃+O₂, CF₄+O₂, C₂F₆+O₂, C₃F₈+O₂, BF₃, PF₃, PF₅, XeF₂, F₂, F₃Cl, FCl₃, ClF₅ and SiF₄.

12. A method according to Claim 11, characterized in that the generation of said fluorine radicals is carried out by applying energy to said gas.

13. A method according to Claim 12, characterized in that said energy is applied in the form of heat, an electron beam, a light beam, a laser light beam, an electric discharge, or microwaves.

14. A method according to Claim 1, characterized in that said method further comprises the step of removing residues attached to said substrate with activated chlorine after the step of removing said film.

15. A method according to Claim 14, characterized in that said activated chlorine is generated by activating chlorine or a chlorine compound.

16. A method according to Claim 15, characterized in that said Chlorine compound is CC*l*₄, BC*l*₃, SiC*l*₄, PC*l*₃ or PC*l*₅.

17. A method according to Claim 1, characterized in that said surface is cooled by a cooler.

18. A method according to Claim 17, characterized in that said cooler is provided in a supporting table on which the substrate is supported.

## Patentansprüche

1. Verfahren zum Entfernen einer Schicht von der Oberfläche eines in einer Kammer untergebrachten Substrates mittels Plasma-Trockenätzen mit den Schritten
Erzeugen von Fluor-Radikalen aus einem fluorhaltigen Gas außerhalb der Kammer; und
getrenntes Einleiten der Fluor-Radikale und eines zweiten Gases, ausgewählt aus der Gruppe, die Wasserstoff, Wasser, einen Alkohol und einen Kohlenwasserstoff umfaßt, in die Kammer, wo sie unter Bildung von Radikalen zur Durchführung des Plasma-Trockenätzens reagieren.

2. Verfahren nach Anspruch 1, dadurch gekennzeichnet, daß die Oberfläche aus einem metallischen Material besteht.

3. Verfahren nach Anspruch 2, dadurch gekennzeichnet, daß das metallische Material Aluminium oder eine Aluminiumlegierung ist.

4. Verfahren nach Anspruch 3, dadurch gekennzeichnet, daß die Oberfläche eine Schicht aus Aluminium oder einer Aluminiumlegierung ist, die auf einer Oberfläche des Substrates ausgebildet ist.

5. Verfahren nach Anspruch 4, dadurch gekennzeichnet, daß die Oberfläche des Substrates aus Silizium oder einer Siliziumverbindung besteht.

6. Verfahren nach Anspruch 5, dadurch gekennzeichnet, daß die Siliziumverbindung Siliziumoxid ist.

7. Verfahren nach Anspruch 6, dadurch gekennzeichnet, daß ein Siliziumhalbleiter mit einer Siliziumoxidschicht überzogen ist, auf welcher die genannte Schicht ausgebildet ist.

8. Verfahren nach Anspruch 1, dadurch gekennzeichnet, daß Wasserstoff, Wasser, Alkohol oder Kohlenwasserstoffe zusammen mit einem Trägergas in die Kammer eingeleitet werden.

9. Verfahren nach Anspruch 8, dadurch gekennzeichnet, daß das Trägergas Sauerstoff oder Argon ist.

10. Verfahren nach Anspruch 8, dadurch gekennzeichnet, daß das Trägergas in Blasen durch eine Lösung mit Wasser oder einem Alkohol hindurchgeleitet und in die Kammer eingeleitet wird, um das Wasser oder den Alkohol in flüssiger Form zu transportieren.

11. Verfahren nach Anspruch 8, dadurch gekennzeichnet, daß die Fluor-Radikale durch Aktivierung eines Gases erzeugt werden, welches aus der Gruppe ausgewählt wird, die SF₆, NF₃, CF₄, C₂F₆, C₃F₈, SF₆ + O₂, NF₃ + O₂, CF₄ + O₂, C₂F₆ + O₂, C₃F₈ + O₂, BF₃, PF₃, PF_{S}, XeF₂, F₂, F₃Cl, FCl₃, ClF₅ und SiF₄ umfaßt.

12. Verfahren nach Anspruch 11, dadurch gekennzeichnet, daß die Erzeugung der Fluor-Radikale dadurch erfolgt, daß dem Gas Energie zugeführt wird.

13. Verfahren nach Anspruch 12, dadurch gekennzeichnet, daß die Energie in Form von Wärme, eines Elektronenstrahls, eines Lichtstrahls, eines Laserstrahls, einer elektrischen Entladung oder von Mikrowellen zugeführt wird.

14. Verfahren nach Anspruch 1, dadurch gekennzeichnet, daß das Verfahren weiterhin das Entfernen von Rückständen, welche nach dem Entfernen der Schicht am Substrat haften, mittels aktiviertem Chlor umfaßt.

15. Verfahren nach Anspruch 14, dadurch gekennzeichnet, daß das aktivierte Chlor durch Aktivierung von Chlor oder Chlorverbindungen erzeugt wird.

16. Verfahren nach Anspruch 15, dadurch gekennzeichnet, daß die Chlorverbindungen CCl₄, BCl₃, SiCl₄, PCl₃ oder PCl₅ sind.

17. Verfahren nach Anspruch 1, dadurch gekennzeichnet, daß die Oberfläche durch einen Kühler gekühlt wird.

18. Verfahren nach Anspruch 17, dadurch gekennzeichnet, daß der Kühler in einem Auflagetisch vorgesehen ist, auf welchem das Substrat liegt.

## Revendications

1. Procédé pour enlever un film de la surface d'un support disposé dans une chambre, par attaque à sec au plasma, comprenant les étapes consistant à:
produire des radicaux de fluor hors de la chambre, à partir d'un gaz contenant du fluor; et
introduire séparément les radicaux de fluor et un deuxième gaz choisi parmi l'hydrogène, l'eau, un alcool et un hydrocarbure, dans la chambre où ils réagissent pour former des radicaux servant à effectuer l'attaque à sec au plasma.

2. Procédé selon la revendication 1, caractérisé en ce que ladite surface est faite d'un matériau métallique.

3. Procédé selon la revendication 2, caractérisé en ce que ledit matériau métallique comprend l'aluminium ou un alliage d'aluminium.

4. Procédé selon la revendication 3, caractérisé en ce que ladite surface comprend un film d'aluminium ou un alliage d'aluminium formé sur une surface d'un support.

5. Procédé selon la revendication 4, caractérisé en ce que la surface dudit support comprend du silicium ou un composé de silicium.

6. Procédé selon la revendication 5, caractérisé en ce que ledit composé de silicium est l'oxyde de silicium.

7. Procédé selon la revendication 6, caractérisé en ce qu'un semi-conducteur de silicium est revêtu d'un film d'oxyde de silicium sur lequel ledit film est formé.

8. Procédé selon la revendication 1, caractérisé en ce que l'hydrogène, l'eau, l'alcool ou l'hydrocarbure est introduit dans ladite chambre avec un gaz porteur.

9. Procédé selon la revendication 8, caractérisé en ce que ledit gaz porteur est l'oxygène ou l'argon.

10. Procédé selon la revendication 8, caractérisé en ce que ledit gaz porteur barbote dans une solution comprenant de l'eau ou un alcool, et est introduit dans ladite chambre de manière à transporter l'eau ou ledit alcool sous une forme fluide.

11. Procédé selon la revendication 8, caractérisé en ce que lesdits radicaux de fluor sont produits en activant un gaz choisi parmi le groupe constitué de SF₆, NF₃, CF₄, C₂F₆, C₃F₈, SF₆ + O₂, NF₃ + O₂, CF₄ + O₂, C₂F₆ + O₂, C₃F₈ + O₂, BF₃, PF₃, PF₅, Xef₂, F₂, F₃Cl, FCl₃, ClF₅ et SiF₄.

12. Procédé selon la revendication 11, caractérisé en ce que la production desdits radicaux de fluor est réalisée en appliquant de l'énergie audit gaz.

13. Procédé selon la revendication 12, caractérisé en ce que ladite énergie est appliquée sous la forme de chaleur, d'un faisceau d'électrons, d'un faisceau de lumière, d'un faisceau de lumière laser, d'une décharge électrique ou de micro-ondes.

14. Procédé selon la revendication 1, caractérisé en ce que ledit procédé comprend en outre l'étape consistant à enlever au chlore activé des résidus attachés audit support après l'étape d'enlèvement dudit film.

15. Procédé selon la revendication 14, caractérisé en ce que ledit chlore activé est produit en activant du chlore ou un composé de chlore.

16. Procédé selon la revendication 15, caractérisé en ce que ledit composé de chlore est CCl₄, BCl₃, SiCl₄, PCl₃ ou PCl₅.

17. Procédé selon la revendication 1, caractérisé en ce que ladite surface est refroidie par un refroidisseur.

18. Procédé selon la revendication 17, caractérisé en ce que ledit refroidisseur est prévu dans une table de soutien sur laquelle est porté le support.
